# EUROPEAN PATENT SPECIFICATION

(11) **EP 1 672 646 B1**
(45) Date of publication and mention of the grant of the patent: **14.10.2009**
(21) Application number: 05027286.3
(22) Date of filing: 14.12.2005
(51) Int. Cl.: G11C 16/04, H01L 21/8247, H01L 27/115

(54) **Electronic memory device having high integration density non volatile memory cells and a reduced capacitive coupling**
Elektronische Speichervorrichtung mit nichtflüchtigen Speicherzellen mit hoher Integrationsdichte und verringerter kapazitiver Kopplung
Dispositif de mémoire électronique ayant des cellules de mémoire non volatiles à densité d'intégration élevée et un couplage capacitif réduit

(30) Priority: 14.12.2004 IT MI20042374
(43) Date of publication of application: 21.06.2006
(73) Proprietor: STMicroelectronics S.r.l., 20041 Agrate Brianza (Milano) (IT)
(72) Inventor: Khouri, Osama, 20146 Milano (IT); Caimi, Carlo, 20092 Cinisello Balsamo (Milano) (IT); Mastrodomenico, Giovanni, 20059 Vimercate (Milano) (IT)
(74) Representative: Niederkofler, Oswald

(56) References cited:
- US-A- 5 656 837
- US-A- 5 867 429
- US-A1- 2003 210 582
- US-A1- 2004 232 496

## Description

### Field of application

The present invention relates to a memory electronic device comprising non-volatile cells and having a high integration density and reduced capacitive coupling interference between the cells.

More specifically the invention relates to a memory electronic device, integrated on a semiconductor substrate, of the type comprising a matrix of non-volatile memory cells, organised in sectors.

The invention more in particular, but not exclusively, relates to a memory electronic device with non-volatile cells of the Flash NAND type and the following description is made with reference to this field of application by way of illustration only.

### Prior art

As it is well known, memory electronic devices comprising non-volatile cells are largely used in multiple apparatuses where storing a great amount of information in a compact support such as cell phones, digital cameras, notebooks and other is required.

In these last years, the circuit architectures of memory devices with non-volatile cells, combined with advanced technological realisation processes, have remarkably developed allowing to improve the operation characteristics of the devices from the point of view of the write, read and erase speed of the single cells.

The simple and reduced structure of the cells of the NAND type is suitable for realising memory devices of the Flash NAND type having high integration density.

Memory devices with Flash NAND cells are semiconductor-integrated devices which thus comprise a plurality of memory cells being matrix-like organised where the cells are organised in rows, called Word lines or WL, and columns, called Bit lines or BL.

The particular matrix-like conformation of these non-volatile memory devices allows to define the key for the comprehension of the technical characteristics.

The memory cells are floating gate transistors and they have a region of conductive material, insulated by a dielectric oxide, above which a control gate is overlapped, everything being arranged above a channel region of the transistor.

According, for example, to a NAND architecture, the memory cells are arranged in series or strings and thus the sole contacts for a string of cells belonging to the same Bit Lines, which are normally 16 or 32 cells, are present on the drain of the drain select transistor or DSL and on the source of the source select transistor or SSL. Along the string the drain of the n-th cell is physically connected (same diffusion) to the source of the cell preceding it (n-1), the source of the cell (n) is in common with the drain of the successive cell (n+1), thus the drain and source electrodes of the single cells are not singularly accessible. Through metallic electrodes, connected to a body of each cell, predetermined voltage values are applied to the memory cell thus making it operative.

The charge stored in the floating gate region determines the logic state of the cell, modifying its threshold voltage. The fundamental characteristic of the memory cell is that of having two states, one with low threshold voltage which, according to the convention, is given the value "0" or "1" and one with high voltage value, "1" or "0". The voltage is applied from the outside through the control gate.

The need of storing, in a more and more reduced space, a greater and greater amount of data has led, in the last times, to the development of devices with multilevel memory cells where, in each cell, different logic states are stored.

The high integration required for memory devices and thus the reduced space between the floating gates of opposite cells, arranged on consecutive World lines, makes it of fundamental importance the accurate control of the distributions of the thresholds in the single cells so as to correctly position the cell at the programmed voltage value. In the devices with multilevel memory cells the control of the thresholds in the single cells is even more important, being the different levels separated within narrow voltage ranges.

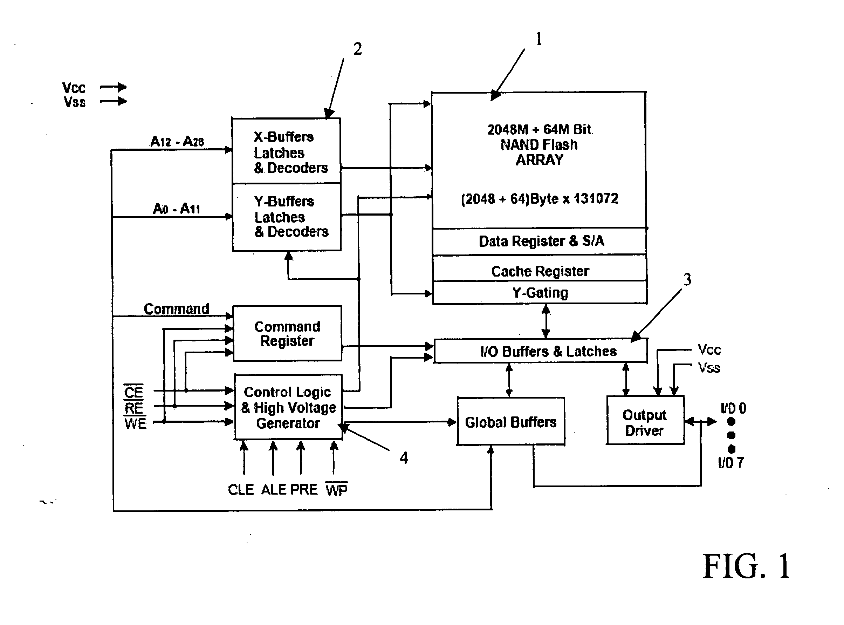

The architecture of a Flash NAND memory consists, as highlighted in figure 1, of an array (1) or matrix, of a row and column decoder (2), of a page buffer (3), of a microcontroller (4) or of other logics such as control logics or state machines, of analogical and digital circuitries.

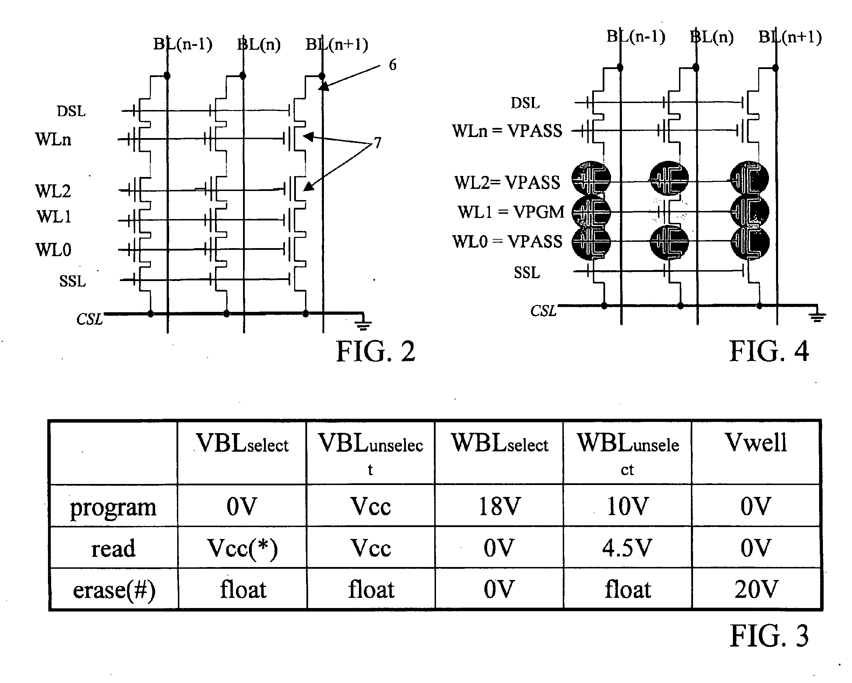

The architecture of the elements forming the array (1) is highlighted in figure 2. The base element of the array is a string (6) consisting of a series of cells (7), connected to a definite Bit line BLn, comprised between a drain selector DSL and a source selector SSL. The string can contain for example 16 or 32 cells (7) in series.

The group of the cells comprised between the two drain and source select transistors, DSL and SSL, and belonging to all the Bit lines BLs, with s comprised between 1 and n, of the matrix defining a sector or block. Naturally, the cells (7) of the same sector or block share, according to the architecture, 16 or 32 Word lines WL.

The group of the sectors or blocks defines the array (1) or matrix.

The biases of the Word lines WL, of the Bit lines BL and of the well or body terminal in the single sectors of the matrix differ according to the operation to be performed in each cell: programming, reading or erasing.

The programming and the erasing of the Flash NAND memory devices occur by means of a procedure called of Flowler-Nordheim tunneling.

In case of a programming operation of a memory cell, a known method, indicated by way of example in the table of figure 3, provides to place at OV the voltage of the bit line BL of the cell to be programmed, thus to place at OV the voltage in the body of the cell to be programmed, Vwell=OV, to suitably enhance the voltage of the cell gate, i.e. of the selected Word line leading it for example to a value equal to 18V, with respect to 10V to which the non selected Word lines of the same selected block are brought.

The logic state of the other cells belonging to the same sector of the cell to be programmed, but not involved in the programming, is kept unaltered by inhibiting the corresponding Bit lines, i.e. keeping them at a voltage value equal to VBL=Vcc and realising a boosting effect in the channels of the non selected cells leading the VWLunselected=Vprogram voltage that in the example is indicatively of about 20V.

As it is known, the read operation of a memory cell, i.e. interpreting the information contained in the cell, occurs through the conductivity or non conductivity of the cell itself. The method provides to place the voltage of the Bit line to be read at a pre-charge value which, in this case, is for example Vcc, VBLselect= Vcc, the voltage value of the other Bit lines VBLunselect at OV, the voltage value of the selected Word line VWLselect at OV, the value of the other Word lines VWLunselect for example at 4,5V and the value of the body voltage Vwell at OV.

An erase operation for Flash NAND memory devices has the advantage that it can be carried out by block or sector. In this case the method provides to place the voltage of all the floating Bit lines, VBLselect=VBLunselect=Vfloat, the voltage of the selected Word line at zero, VWLselect at 0V, the voltage of the other Word lines VWLunselect at Vfloat and the body voltage Vwell for example at 20V.

During the programming of a cell in a memory device a lot of attention must be paid to the presence of disturbances, which can both influence the voltage value stored in the single cell to be programmed and cause a variation of the voltages stored in the adjacent cells.

In the devices with non-volatile memory cells the undesired capacitive couplings between the cells, are among the main responsible for the disturbances and the so called "widening of the distributions".

Naturally, in multilevel devices "the widening of the disturbances" is more dangerous being the thresholds relative to the different levels or logic states separated within narrow voltage ranges.

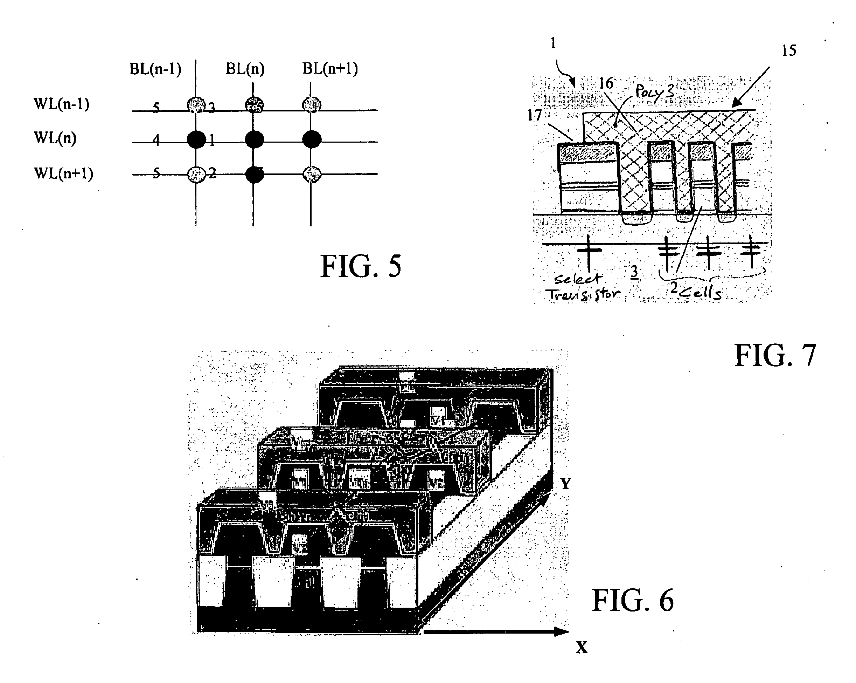

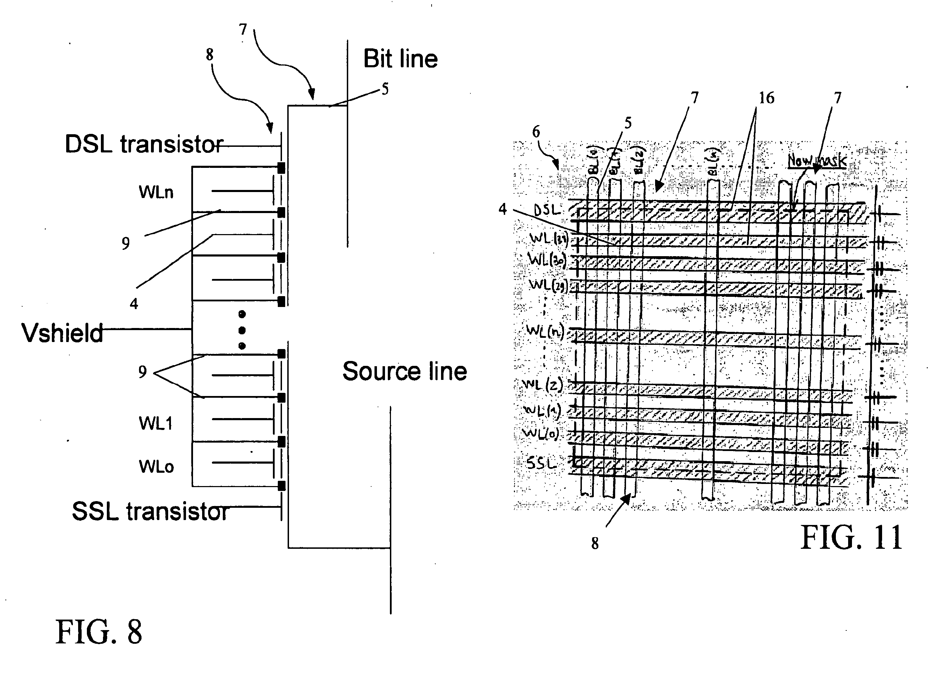

In a memory of the Flash NAND type, with high density, the main parasite capacitive components are identified, with reference to figures 7 and 8, with the capacities along:
1. the direction Y of the Bit Lines;
2. the direction X of the Word lines;
3. direction XY diagonal couplings.

The three identified parasite capacities take different values from each other and typically, in the order indicated, they have decreasing values.

The presence of these parasite capacities creates serious problems, in fact, they tend to modify the voltages in the cells and in particular during the programming operation.

A solution is shown in the US patent application No. 2004/0232496 to Chen et al., which discloses a semiconductor structure as flash EEPROM or other type of memory cell array comprising a conductor that extends along the columns between the memory cells of opposite word lines.

Another solution is shown in the US patent US-A-5 867 429 which discloses reduction of electric field coupling in a NAND memory by placing a conductive shield between floating gates of adjacent rows, wherein the conductive shield is connected to ground or some other potential.

With particular reference to figure 4, during the programming of the centrally arranged cell the floating gate voltage of this cell can, as effect of the parasite capacities which are formed with the floating gate of the adjacent cells, be modified. Naturally, the presence of the parasite capacities is due to the geometry of the cells, to the lithography and to the presence of the dielectric placed between the opposite Word lines, in combination with the limited distance from one another due to the high integration degree of the cells in these devices.

A summary scheme of the parasite capacities present in a device portion, indicated in figure 6. From suitable measurements carried out by the Applicant it has been possible to observe how the total of the voltage variation Vth of a cell, due to all the parasite capacities of the surrounding cells, erased with voltage for example equal to 20V and programmed with method ISPP, i.e. with same values of ΔVₛₜₑₚ= 0,5V and tₛₜₑₚ=20µs, is about of 500mV. It has been understood how the main part of the voltage variation Vth of a cell is mainly due to the contribution of the capacitive couplings along the Bit Lines, i.e. along the direction Y.

This confirms how the value of the parasite capacities, which are created along the Bit lines, remarkably influences the threshold voltage of the single cells and thus the correctness of the programmable and programmed values.

The technical problem underlying the present invention is that of providing a device of non-volatile memory cells of the Flash NAND type, matrix-like organised and comprising one or more sectors, having such structural and functional characteristics as to allow to reduce the capacitive coupling between floating gates regions belonging to opposite cells placed on consecutive Word lines allowing to carry out a reliable programming also in high integration devices overcoming the drawbacks indicated in the devices realised according to the prior art.

### Summary of the invention

The solution idea underlying the present invention is that of providing a floating conductive shield interposed between the rows or Word lines of the sectors of the matrix of the memory device.

On the basis of this solution idea the technical problem is solved by a device of non-volatile memory cells as previously indicated and defined by the characterising part of claim 1.

The problem is also solved by a method which allows to suitably bias the conductive shield during the program, read or erase operations as defined by the characterising part of claim 6.

The characteristics and the advantages of the device and of the method according to the invention will be apparent from the following description of an embodiment thereof given by way of indicative and non limiting example with reference to the annexed drawings.

### Brief description of the drawings

In these drawings:
Figure 1 schematically show a circuit comprising a Flash NAND memory device realised according to the prior art;
Figure 2 shows an architecture of the base elements which form an array or matrix;
Figure 3 shows a table reporting some biasing values according to a programming method known for a cell of the array of figure 2;
Figure 4 shows a portion of a device with nine cells with the indications of the voltages of the cells during the programming of the central cell according to the method reported in figure 3;
Figure 5 shows an exemplary scheme of a device portion comprising nine cells identified by Word lines and Bit lines;
Figure 6 shows a perspective view of a device portion realised according to the prior art;
Figure 7 shows an exemplary scheme of a device portion realised according to the present invention;
Figures 8 e 9 respectively show an architecture of a Flash NAND memory device and an example of a possible circuit scheme;
Figure 10 shows a table comprising some examples of biasing of a Flash NAND memory device realised according to method of the present invention;
Figure 11 shows a schematic view from above of a memory cell matrix.

### Detailed description

With reference to figure 7 a portion 1 is described of a Flash NAND memory electronic device, integrated on a semiconductor substrate 3, of the type comprising a matrix 6 of non-volatile Flash NAND memory cells 2.

The matrix 6 of the memory device 1, highlighted in figure 11, is organised in one or more sectors 7 comprising rows or Word lines 4 and columns or Bit lines 5 of memory cells 2.

Each sector 7 or block comprising n strings 8, where n is the number of the Bit lines 5 defining the electronic device 1.

According to a current architecture, each string 8 has 16 or 32 non-volatile memory cells 2, all being connected to a same Bit line 5 through a drain select transistor DSL and a source select transistor SSL.

The group of the cells 2 comprised between two select transistors, DSL and SSL, and belonging to all the bit lines BL of the string 8 of the matrix 6 define the sector 7 or block.

Advantageously according to the present invention, as highlighted in figure 7, above the substrate 3 and between opposite Word lines 4, i.e. between a WLn-1 and a successive one WLn, a lateral coating 15 is provided comprising at least one conductive layer 16.

Suitably, the conductive layer 16 has a conformation laterally shaped on the cells 2 along the direction of the bit lines 5.

Advantageously, according to the present embodiment, the coating 15 also comprises a thin insulating layer 17 arranged below the conductive layer 16 which allows to insulate the cells 2 and in particular the respective floating gates from the conductive layer 16.

Naturally, in the case of a memory device 1 with cells 2 comprising lateral spacers, placed along the direction of the Bit lines 5, the insulating layer 17 will not be present.

The conductive layer 16, of the coating 15, defines at least between the opposite Word lines 4, on each sector 7 of the matrix 6, a conductive shield which, by means of a contact terminal 9 is suitably biased, as shown in particular in figure 8.

The conductive layer 16 biased by means of the contact terminal 9 allows to minimise and/or to eliminate the effect of the capacitive coupling which would be created, along the string 8, during the programming operation.

Further, the conductive layer 16, during the various program, read or erase, operations of each sector 7 of the matrix 6, takes a different biasing value. This value, suitably programmed, allows to optimise the performances of the single factor 7 minimising the noises during the single operations.

In particular, as shown in figures 8, 9 and 11, the conductive layers 16 of a same sector 7 have the contact terminals 9 connected to each other and placed simultaneously at a value equal to Vshield. The conductive layer 16 of a same sector 7 is thus equi-potential. The Vshield value and thus the voltage value of the contact terminal 9 is set by a decoder 11 which is in turn regulated by a control unit 12 or microcontroller. The control unit 12 thus defines the voltage of the conductive layer 16.

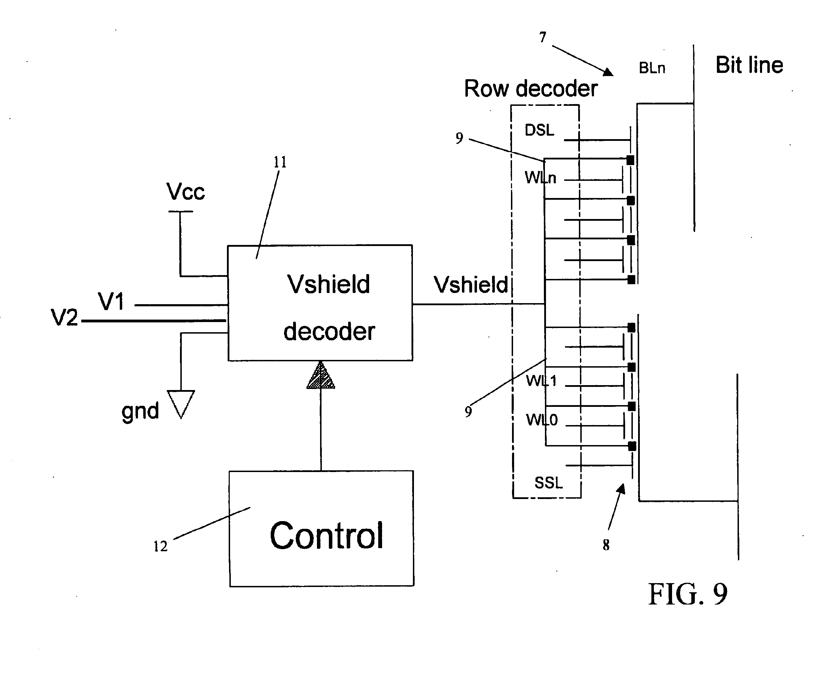

In figure 9 the decoder takes in input four different values, a supply voltage Vcc, a ground voltage gnd and two further voltage values, V1 and V2, different with respect to the previous ones.

Naturally according to the typology of the memory device 1, if with two levels or multilevel, the input values of the decoder 11 can be of a different number and they can take different values. Moreover, each value can be suitably generated by possible blocks placed upstream of the decoder 11.

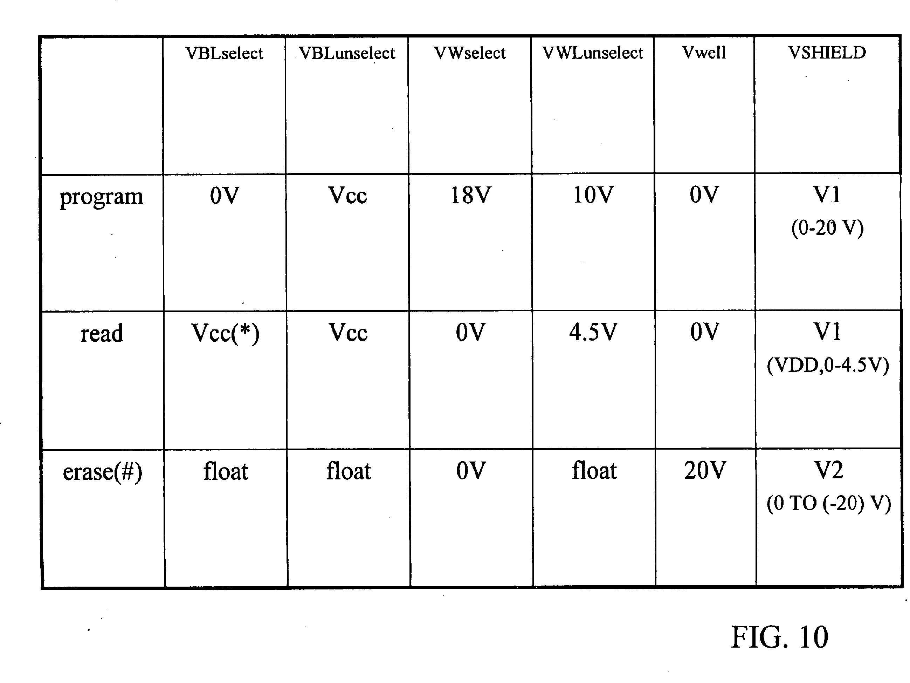

A method defines the voltage values to be applied to the contact terminal 9, of a sector 7 of the matrix 6, during the program, read and erase operations of each cell 2 contained in the sector 7 so as to eliminate the parasite capacities. The voltage values to be applied to the contact terminal 9 are reported in the table of figure 10.

In particular, during a program operation of a cell 2, the contact terminal 9 of the conductive layer 16 is placed at a voltage comprised between 0V and 20V, for example 10V.

In this way the conductive layer 16 of the whole sector 7 will be biased avoiding the formation of parasite capacities between the floating gates of the cells 2 placed on opposite Word lines 4.

For a read operation of a cell 2 the contact terminal 9 will be placed at a voltage equal to V1 which will take values of Vdd, or a value comprised between 0V and 4,5V.

In this way during the read operation the whole conductive layer 16 of the sector 7 is equi-potential and the current which will be absorbed during this operation will be exactly the one absorbed by the transistor of the selected cell 2 without possibility of dispersion.

During the erase step the conductive layer 16 is placed at a voltage equal to V2 a value comprised between 0V and -20V, preferably equal to about -10V. During the erase operation the body Vwell voltage is placed positive and thus by placing the voltage of the conductive layer 16 negative the erase operation on the whole sector 7 of the matrix 6 is remarkably facilitated.

For example, by placing the value of V2 for example at -10V and the value of Vwell for example equal to + 10V, the difference of potential is of 20V and this favours the migration of the charges outside the sector 7 of the matrix 6.

Naturally, the biasing of the conductive layer 16 can occur with different voltage values, specific according to the design needs.

In particular a biasing will be realised independently from the single sectors 7 of the same matrix 6, by setting voltages different from the respective contact terminals 9.

The present invention can be applied to devices with floating gate memory cells showing different embodiments, all however within the same scope of protection.

## Claims

1. Memory electronic device of the Flash NAND type comprising non-volatile cells and having a high integration density, of the type integrated on a semiconductor substrate (3) and comprising one matrix (6) of cells organised in rows or Word lines (4) and columns or Bit lines (5) in sectors (7) of memory cells (2), wherein between the cells (2) of opposite Word lines (4) belonging to at least one of said sectors (7) of said matrix (6) a lateral coating (15) is provided comprising at least one conductive layer (16), one contact terminal (9) being provided to contact this conductive layer and **characterized by** applying selectively to said conductive layer (16) different biasing potentials during the program, read or erase operation of the memory cells.

2. Device according to claim 1 **characterised in that** said coating (15) is laterally shaped on said cells (2) along the direction of said Bit lines (5).

3. Device according to claim 2 **characterised in that** said coating (15) comprises at least one this insulating layer (17) below said conductive layer (16).

4. Device according to one of the preceding claims **characterised in that** the contact terminals (9) of conductive layers (16) interposed between opposite Word lines (4) are equi-potential.

5. Device according to one or more of the preceding claims **characterised in that** the contact terminals (9) of said conductive layers (16) interposed between opposite Word lines (4) are placed at different potentials from one another.

6. Method for programming a memory electronic device with Flash NAND non-volatile cells integrated on a semiconductor substrate (3) and comprising one matrix (6) with rows (4) and columns (5) organised in sectors (7) of cells (2) wherein said sector (7) of said matrix (6) has a coating (15) comprising a conductive layer (16) arranged between said cells of said opposite Word lines (4), said conductive layer (16) being biased by means of a contact terminal (9) and **characterized in that** the bias is a positive voltage V1 during the program and read operations and at a negative voltage V2 during the erase operations.

7. Method according to claim 6 **characterised in that** during said program operation said biasing voltage V1 of said conductive layer (16) is a value comprised between 0V and 20V.

8. Method according to claim 6 **characterised in that** said voltage V1 during said program operation is equal to a biasing voltage of the Word lines not selected in programming.

9. Method according to claim 6 **characterised in that** during said read operation of said biasing voltage V1 of said conductive layer (16) is a value equal to a supply voltage Vdd or to a voltage comprised between 0V and 4,5V.

10. Method according to claim 6 **characterised in that** during said read operation said biasing voltage V1 of said conductive layer (16) is equal to a biasing voltage of the Word lines non selected in reading.

11. Method according to claim 6 **characterised in that** during said erase operation said biasing value V2 of said conductive layer (16) is comprised between 0V and -20V.

## Patentansprüche

1. Elektronische Speichervorrichtung vom NAND-Flashtyp, der nichtflüchtige Zellen umfasst und eine hohe Integrationsdichte aufweist, von dem Typ, der auf einem Halbleitersubstrat (3) integriert ist und eine Matrix (6) von in Reihen oder Wortleitungen (4) und Spalten oder Bitleitungen (5) organisierten Zellen in Sektoren (7) von Speicherzellen (2) umfasst, wobei zwischen den Zellen (2) gegenüberliegender Wortleitungen (4), die zu wenigstens einem der Sektoren der Matrix (6) gehören, eine laterale Beschichtung (15) vorgesehen ist, die wenigstens eine leitende Schicht (16) umfasst, wobei zum Kontaktieren dieser leitenden Schicht ein Kontaktanschluss (9) vorgesehen ist, **dadurch gekennzeichnet, dass** an die leitende Schicht (16) während des Programmier-, Lese- oder Löschvorgangs der Speicherzellen selektiv unterschiedliche Vorspannungen angelegt werden.

2. Speichervorrichtung nach Anspruch 1, **dadurch gekennzeichnet, dass** die Beschichtung (15) lateral auf den Zellen (2) entlang der Richtung der Bitleitungen (2) geformt ist.

3. Speichervorrichtung nach Anspruch 2, **dadurch gekennzeichnet, dass** die Beschichtung (15) wenigstens eine dies isolierende Schicht (17) unterhalb der leitenden Schicht (16) aufweist.

4. Speichervorrichtung nach einem der vorangehenden Ansprüche, **dadurch gekennzeichnet, dass** die Kontaktanschlüsse (9) der zwischen gegenüberliegenden Wortleitungen (4) liegenden leitenden Schichten (16) äquipotential sind.

5. Speichervorrichtung nach einem oder mehreren der vorangehenden Ansprüche, **dadurch gekennzeichnet, dass** die Kontaktanschlüsse (9) der zwischen gegenüberliegenden Wortleitungen (4) liegenden leitenden Schichten (16) auf voneinander unterschiedliche Potentiale gebracht werden.

6. Verfahren zum Programmieren einer elektronischen Speichervorrichtung mit nichtflüchtigen NAND-Flashzellen, die auf einem Halbleitersubstrat (3) integriert ist und eine Matrix (6) mit in Sektoren (7) von Zellen (2) organisierten Reihen (4) und Spalten (5) umfasst, wobei der Sektor (7) der Matrix (6) eine Beschichtung (15) aufweist, die eine zwischen den Zellen der gegenüberliegenden Wortleitungen (4) angeordnete, leitende Schicht (16) umfasst, wobei die leitende Schicht (16) mittels eines Kontaktanschlusses (9) unter Vorspannung gesetzt wird**, dadurch gekennzeichnet, dass** die Vorspannung während der Programmier- und Lesevorgänge eine positive Spannung V1 und während der Löschvorgänge eine negative Spannung V2 ist.

7. Verfahren nach Anspruch 6, **dadurch gekennzeichnet, dass** während des Programmiervorgangs die Vorspannungsspannung V1 der leitenden Schicht (16) einen Wert zwischen 0V und 2V aufweist.

8. Verfahren nach Anspruch 6, **dadurch gekennzeichnet, dass** die Spannung V1 während des Programmiervorgangs gleich einer Vorspannungsspannung der bei einer Programmierung nicht ausgewählten Wortleitungen ist.

9. Verfahren nach Anspruch 6, **dadurch gekennzeichnet, dass** während des Lesevorgangs die Vorspannungsspannung V1 der leitenden Schicht (16) ein Wert gleich einer Versorgungsspannung Vdd oder einer zwischen 0V und 4,5V liegenden Spannung ist.

10. Verfahren nach Anspruch 6, **dadurch gekennzeichnet, dass** die Vorspannungsspannung V1 der leitenden Schicht (16) während des Lesevorgangs gleich einer Vorspannungsspannung der beim Lesen nicht ausgewählten Wortleitungen ist.

11. Verfahren nach Anspruch 6, **dadurch gekennzeichnet, dass** der Vorspannungsspannungswert V2 der leitenden Schicht (16) während des Löschvorgangs zwischen 0V und -20V liegt.

## Revendications

1. Dispositif électronique à mémoire du type flash NON ET comprenant des cellules non volatiles et ayant une grande densité d'intégration, du type intégré sur un substrat semi-conducteur (3) et comprenant une matrice (6) de cellules organisée en rangées ou lignes de mot (4) et en colonnes ou lignes de bit (5) en des secteurs (7) de cellules de mémoire (2), dans lequel, entre les cellules (2) de lignes de mot (4) opposées appartenant à au moins l'un desdits secteurs (7) de ladite matrice (6), un revêtement latéral (15) est prévu, comprenant au moins une couche conductrice (16), une borne de contact (9) étant prévue pour être en contact avec cette couche conductrice, et **caractérisé par** l'application de manière sélective à ladite couche conductrice (16) de différents potentiels de polarisation pendant l'opération de programmation, de lecture ou d'effacement des cellules de mémoire du programme.

2. Dispositif selon la revendication 1, **caractérisé en ce que** ledit revêtement (15) est formé latéralement sur lesdites cellules (2) le long de la direction desdites lignes de bit (5).

3. Dispositif selon la revendication 2, **caractérisé en ce que** ledit revêtement (15) comprend au moins une couche isolante (17) au-dessous de ladite couche conductrice (16).

4. Dispositif selon l'une des revendications précédentes, **caractérisé en ce que** les bornes de contact (9) des couches conductrices (16) interposées entre des lignes de mot (4) opposées sont au même potentiel.

5. Dispositif selon une ou plusieurs des revendications précédentes, **caractérisé en ce que** les bornes de contact (9) desdites couches conductrices (16) interposées entre des lignes de mot (4) opposées sont placées à des potentiels différents les uns des autres.

6. Procédé pour programmer un dispositif électronique à mémoire avec des cellules non volatiles de type flash NON ET intégré sur un substrat semi-conducteur (3) et comprenant une matrice (6) avec des rangées (4) et des colonnes (5) organisées en des secteurs (7) de cellules (2), dans lequel ledit secteur (7) de ladite matrice (6) comporte un revêtement (15) comprenant une couche conductrice (16) agencée entre lesdites cellules desdites lignes de mot (4) opposées, ladite couche conductrice (16) étant polarisée au moyen d'une borne de contact (9), et **caractérisé en ce que** la polarisation est une tension positive V1 pendant les opérations de programmation et de lecture et une tension négative V2 pendant les opérations d'effacement.

7. Procédé selon la revendication 6, **caractérisé en ce que,** pendant ladite opération de programmation, ladite tension de polarisation V1 de ladite couche conductrice (16) est une valeur comprise entre 0 V et 20 V.

8. Procédé selon la revendication 6, **caractérisé en ce que** ladite tension V1 pendant ladite opération de programmation est égale à une tension de polarisation des lignes de mot qui ne sont pas sélectionnées pour la programmation.

9. Procédé selon la revendication 6, **caractérisé en ce que**, pendant ladite opération de lecture, ladite tension de polarisation V1 de ladite couche conductrice (16) est une valeur égale à une tension d'alimentation Vdd ou à une tension comprise entre 0 V et 4,5 V.

10. Procédé selon la revendication 6**, caractérisé en ce que,** pendant ladite opération de lecture, ladite tension de polarisation V1 de ladite couche conductrice (16) est égale à une tension de polarisation des lignes de mot qui ne sont pas sélectionnées pour la lecture.

11. Procédé selon la revendication 6, **caractérisé en ce que,** pendant ladite opération d'effacement, ladite valeur de polarisation V2 de ladite couche conductrice (16) est comprise entre 0 V et -20 V.
